# EUROPEAN PATENT APPLICATION

(11) **EP 4 791 126 A1**
(43) Date of publication of application: **12.08.2026**
(21) Application number: 23954789.6
(22) Date of filing: 05.10.2023
(51) Int. Cl.: H05K 3/46

(54) **PRINTED WIRING BOARD**

(71) Applicant: MITSUBISHI ELECTRIC CORPORATION, Chiyoda-ku Tokyo 100-8310 (JP)
(72) Inventor: ITO, Yohei, Tokyo 100-8310 (JP); TAKANISHI, Kenjiro, Tokyo 100-8310 (JP); SAKAMOTO, Tatsuya, Tokyo 100-8310 (JP); ARAI, Hitoshi, Tokyo 100-8310 (JP)
(74) Representative: Mewburn Ellis LLP
(86) International application number: PCT/JP2023/036389
(87) International publication number: WO 2025/074578

(57) **Abstract**

A printed circuit board (100) includes two surface conductor layers (111), one or more internal conductor layers, and a plurality of insulating layers (114). The one or more internal conductor layers include one or more low thermal expansion conductor layers (114) in which a conductor part is formed by a conductor whose thermal expansion coefficient is lower than those of conductors of the two surface conductor layers. At least one of the one or more low thermal expansion conductor layers includes two or more regions in which a plurality of penetration holes are provided in the conductor part. Hole densities of the two or more regions differ from each other.

## Description

### Technical Field

The present disclosure relates to a printed circuit board.

### Background Art

The printed circuit board is mounted with electronic components whose thermal expansion coefficients differ from that of the printed circuit board.

When a thermal expansion difference between the printed circuit board and the mounted components is large, a crack in a solder joint is likely to occur due to the influence of a heat cycle. In this case, the lifespan of the printed circuit board is shortened.

As a conventional technique for reducing the thermal expansion difference between the printed circuit board and the mounted components, a printed circuit board that includes a core is known.

Patent Literature 1 discloses a package substrate.

In this package substrate, a metal with low thermal expansion is used as the core, and build-up wiring layers are layered on both sides of the core. Further, a semiconductor chip is flip-chip connected to the package substrate, and a plurality of penetration holes (or slits) are formed in the core.

### Citation List

### Patent Literature

Patent Literature 1: JP 2004-253738 A

### Summary of Invention

### Technical Problem

Various components with different thermal expansion coefficients are mounted on the printed circuit board. Therefore, it is preferable to adjust the thermal expansion coefficient of the printed circuit board according to each component.

It is preferable to have the low thermal expansion coefficient only near components with low thermal expansion. However, the thermal expansion difference on the surface of the printed circuit board increases in such a case.

The present disclosure aims to enable the thermal expansion coefficient of the printed circuit board to be controlled according to the thermal expansion coefficient of each mounted component.

### Solution to Problem

A printed circuit board of the present disclosure that is built with a plurality of layers includes:
two surface conductor layers that are formed on upper and lower surfaces of the printed circuit board;
one or more internal conductor layers that are formed inside the printed circuit board; and
a plurality of insulating layers that electrically insulate the two surface conductor layers and the one or more internal conductor layers, wherein
the one or more internal conductor layers include one or more low thermal expansion conductor layers in which a conductor part is formed by a conductor whose thermal expansion coefficient is lower than those of conductors of the two surface conductor layers,
at least one of the one or more low thermal expansion conductor layers includes two or more regions in which a plurality of penetration holes are provided in the conductor part, and
hole densities of the two or more regions differ from each other.

### Advantageous Effects of Invention

According to the present disclosure, since two or more regions with different hole densities are provided on a low thermal expansion conductor layer of the printed circuit board, it is possible to control the thermal expansion coefficient of the printed circuit board according to the thermal expansion coefficient of each mounted component.

### Brief Description of Drawings

Fig. 1 is a partial cross-sectional diagram of a printed circuit board 100 in Embodiment 1.
Fig. 2 is a partial cross-sectional diagram of the printed circuit board 100 in Embodiment 1.
Fig. 3 is a partial plan diagram of a low thermal expansion conductor layer 112a in Embodiment 1.
Fig. 4 is a partial plan diagram of a low thermal expansion conductor layer 112b in Embodiment 1.
Fig. 5 is a partial plan diagram of a low thermal expansion conductor layer 112 in Embodiment 1.
Fig. 6 is a partial plan diagram of the low thermal expansion conductor layer 112 in Embodiment 1.
Fig. 7 is a partial cross-sectional diagram of the printed circuit board 100 in an example.
Fig. 8 is a partial cross-sectional diagram of the printed circuit board 100 in an example.
Fig. 9 is a partial cross-sectional diagram of the printed circuit board 100 in an example.
Fig. 10 is a partial cross-sectional diagram of the printed circuit board 100 in an example.
Fig. 11 is a partial cross-sectional diagram of the printed circuit board 100 in an example.
Fig. 12 is a partial cross-sectional diagram of the printed circuit board 100 in an example.
Fig. 13 is a partial cross-sectional diagram of the printed circuit board 100 in an example.
Fig. 14 is a partial plan diagram of the low thermal expansion conductor layer 112 in an example.
Fig. 15 is a partial plan diagram of the low thermal expansion conductor layer 112b in an example.
Fig. 16 is a partial plan diagram of the low thermal expansion conductor layer 112 in an example.

### Description of Embodiments

In the Embodiments and drawings, the same elements or corresponding elements are denoted by the same reference sign. Description of an element denoted by the same reference sign as that of an element that has been described will be suitably omitted or simplified.

### Embodiment 1.

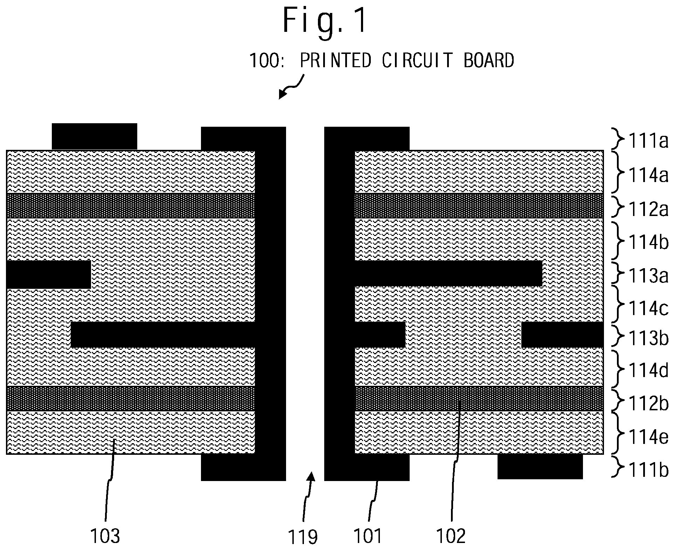

A printed circuit board 100 will be described based on Figs. 1 to 16.

### *** Description of Configuration ***

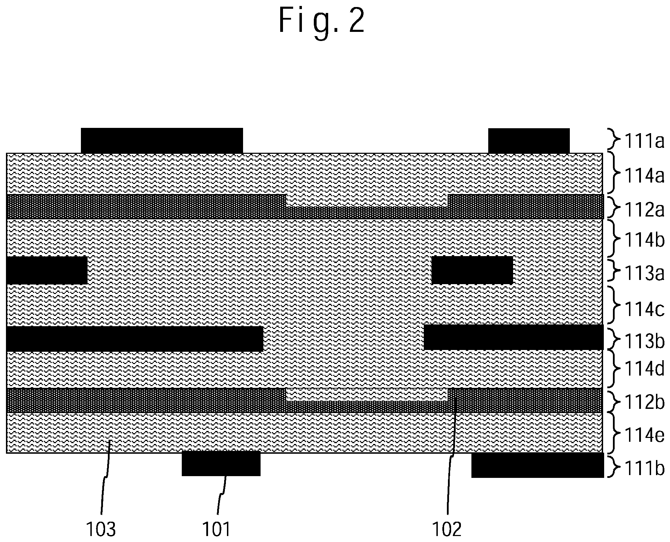

A configuration of the printed circuit board 100 will be described based on Figs. 1 and 2.

The printed circuit board 100 is a printed circuit board (a multi-layer printed circuit board) that is build up with a plurality of layers.

The printed circuit board 100 includes two surface conductor layers 111.

In Fig. 1, the printed circuit board 100 includes a surface conductor layer 111a and a surface conductor layer 111b.

The surface conductor layer 111 is a conductor layer that is formed on both the upper and lower surfaces of the printed circuit board 100.

The conductor layer is a layer that has a part (a conductor part) that is formed of a conductor.

The conductor of the surface conductor layer 111 is referred to as a wiring conductor 101.

The printed circuit board 100 includes one or more internal conductor layers.

The internal conductor layer is a conductor layer that is formed inside the printed circuit board 100.

Each of a low thermal expansion conductor layer 112 and a same-type conductor layer 113 is the internal conductor layer.

The conductor of the low thermal expansion conductor layer 112 is a conductor whose thermal expansion coefficient is lower than that of the wiring conductor 101. The conductor of the low thermal expansion conductor layer 112 is referred to as a low thermal expansion conductor 102.

The conductor of the same-type conductor layer 113 is a conductor of the same type as the conductor of the surface conductor layer 111.

In Fig. 1, the printed circuit board 100 includes two low thermal expansion conductor layers 112 and two same-type conductor layers 113.

Each of a low thermal expansion conductor layer 112a and a low thermal expansion conductor layer 112b is composed of the low thermal expansion conductor 102 and an insulating material 103. However, since a part of the low thermal expansion conductor layer 112 illustrated in Fig. 1 is the conductor part, a part (an insulating part) that is formed by the insulating material 103 is not indicated in the low thermal expansion conductor layer 112 in Fig. 1.

Each of a same-type conductor layer 113a and a same-type conductor layer 113b is composed of the wiring conductor 101 and the insulating material 103.

At least one of the same-type conductor layers 113 is positioned between the two low thermal expansion conductor layers 112.

In Fig. 1, the same-type conductor layer 113a and the same-type conductor layer 113b are positioned between the low thermal expansion conductor layer 112a and the low thermal expansion conductor layer 112b.

The printed circuit board 100 includes a plurality of insulating layers 114.

The plurality of insulating layers 114 electrically insulate the two surface conductor layers 111 and the one or more internal conductor layers.

The insulating layer 114 is a layer that is formed of the insulating material 103 inside the printed circuit board 100.

In Fig. 1, the printed circuit board 100 includes five insulating layers 114.

An insulating layer 114a is positioned on the inner surface of the surface conductor layer 111a. The low thermal expansion conductor layer 112a is positioned on the inner surface of the insulating layer 114a. The insulating layer 114a insulates the surface conductor layer 111a and the low thermal expansion conductor layer 112a.

An insulating layer 114b is positioned on the inner surface of the low thermal expansion conductor layer 112a. The same-type conductor layer 113a is positioned on the inner surface of the insulating layer 114b. The insulating layer 114b insulates the low thermal expansion conductor layer 112a and the same-type conductor layer 113a.

An insulating layer 114c is positioned on the inner surfaces of the same-type conductor layer 113a and the same-type conductor layer 113b. The insulating layer 114c insulates the same-type conductor layer 113a and the same-type conductor layer 113b.

An insulating layer 114d is positioned on the inner surface of a low thermal expansion conductor layer 112d. The same-type conductor layer 113b is positioned on the inner surface of the insulating layer 114d. The insulating layer 114d insulates the same-type conductor layer 113b and the low thermal expansion conductor layer 112b.

An insulating layer 114e is positioned on the inner surface of the surface conductor layer 111b. The low thermal expansion conductor layer 112b is positioned on the inner surface of the insulating layer 114e. The insulating layer 114e insulates the low thermal expansion conductor layer 112b and the surface conductor layer 111b.

A through hole 119 is provided in the printed circuit board 100.

The through hole 119 penetrates through the printed circuit board 100.

The diameter of the through hole 119 is constant inside the printed circuit board 100.

The through hole 119 is formed of the same type of conductor as the conductor of the surface conductor layer 111, and electrically connects the two surface conductor layers 111 and at least one of the internal conductor layers.

The wiring conductor 101 of the through hole 119 electrically connects the wiring conductor 101 of the two surface conductor layers 111, and the low thermal expansion conductor 102 of at least one of the low thermal expansion conductor layers 112, for example.

In Fig. 1, the wiring conductor 101 of the through hole 119 is electrically connected to the wiring conductor 101 of each of the surface conductor layers 111, to the low thermal expansion conductor 102 of each of the low thermal expansion conductor layers 112, and to the wiring conductor 101 of each of the same-type conductor layers 113.

In at least one of the low thermal expansion conductor layers 112, the thickness of a part of the low thermal expansion conductor layer 112 differs from the thickness of another part.

In Fig. 2, a part of each of the low thermal expansion conductor layer 112a and the low thermal expansion conductor layer 112b is thinner than the other part.

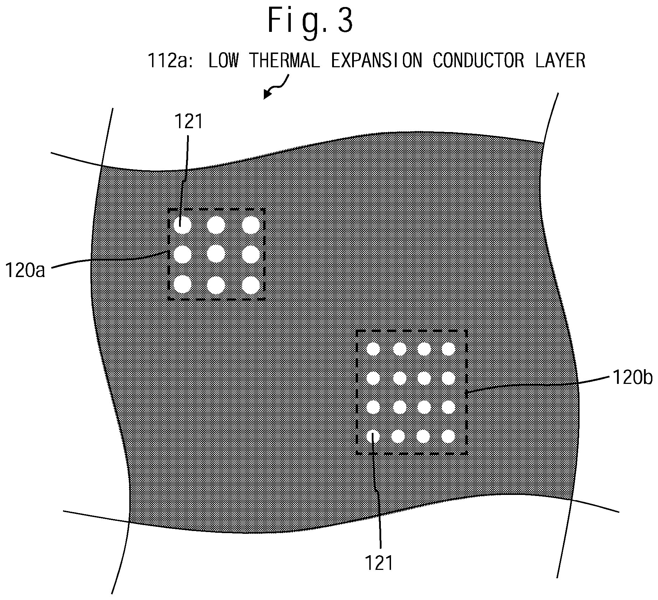

A configuration of the low thermal expansion conductor layer 112 will be described based on Figs. 3 to 6.

At least one of the low thermal expansion conductor layers 112 includes one or more regions 120 in the conductor part. The region 120 is a region in which a plurality of penetration holes 121 are provided.

In Fig. 3, the low thermal expansion conductor layer 112a includes a region 120a and a region 120b in the conductor part. Further, the plurality of penetration holes 121 are provided in each of the region 120a and the region 120b.

The region 120 is a region whose position is the same as that of one of component mounting regions of the two surface conductor layers 111 in the planar direction. The component mounting region is a region on which components are mounted.

In Fig. 3, the region 120a is a region that is directly beneath a component mounting region a of the surface conductor layer 111a. Further, the region 120b is a region that is directly beneath a component mounting region b of the surface conductor layer 111a.

At least one of the low thermal expansion conductor layers 112 includes two or more regions 120 in the conductor part. The hole densities of the two or more regions 120 differ from each other. The hole density is also referred to as porosity.

In Fig. 3, the hole density of the region 120a differs from the hole density of the region 120b.

The printed circuit board 100 includes two or more low thermal expansion conductor layers 112, each of which includes the region 120 in the conductor part, with the positions of the regions in the planar direction being different from each other.

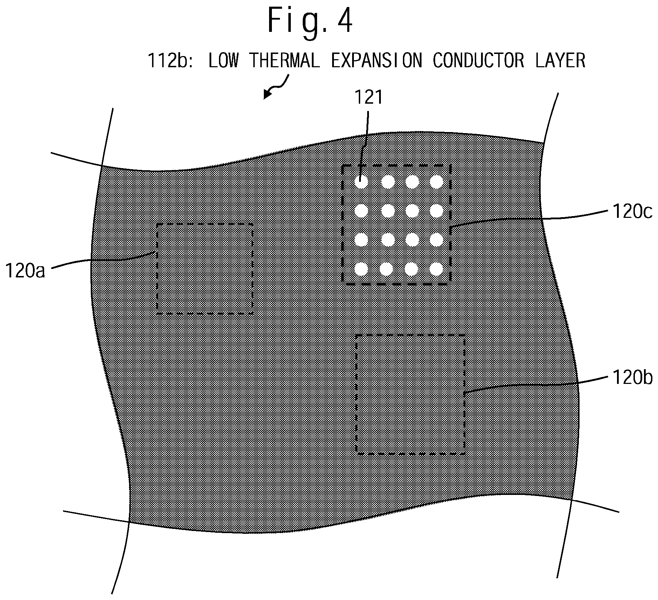

In Fig. 4, the low thermal expansion conductor layer 112b includes a region 120c in which the plurality of penetration holes 121 are provided in the conductor part. The region 120c is a region that is directly above a component mounting region c of the surface conductor layer 111b.

The position of the region 120c of the low thermal expansion conductor layer 112b differs from the positions of the regions (120a, 120b) of the low thermal expansion conductor layer 112a in the planar direction.

A plurality of penetration holes 129 whose hole densities gradually vary as the penetration holes 129 are farther away from the region 120 are provided in the conductor part around at least one of the regions 120.

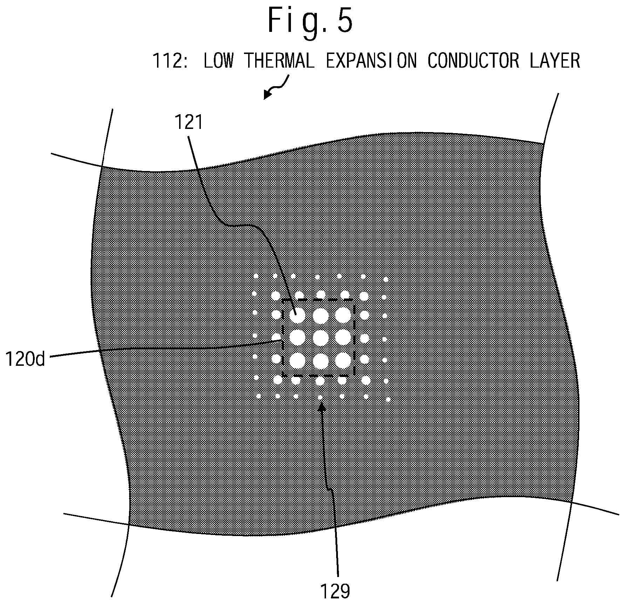

In Fig. 5, the low thermal expansion conductor layer 112 includes a region 120d in which the plurality of penetration holes 121 are provided in the conductor part. The plurality of penetration holes 129 are provided around the region 120d in the conductor part. The diameters of the penetration holes 129 decrease as the penetration holes 129 are farther away from the region 120d. Thereby, the hole densities around the region 120d gradually decrease as the penetration holes 129 are farther away from the region 120d.

In Fig. 5, although the diameters of the penetration holes 129 decrease as the penetration holes 129 are farther away from the region 120d, the diameters of the penetration holes 129 may increase as the penetration holes 129 are farther away from the region 120d.

At least one of the regions 120 includes two or more sections 122. The section 122 is a section in which the plurality of penetration holes 121 are provided.

The hole densities of the two or more sections 122 differ from each other.

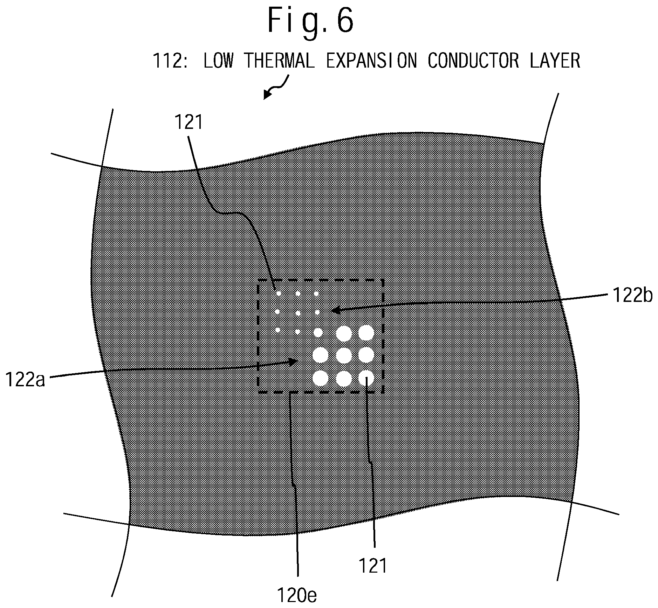

In Fig. 6, the low thermal expansion conductor layer 112 includes a region 120e in the conductor part. The region 120e includes a section 122a and a section 122b. Each of the section 122a and the section 122b is provided with the plurality of penetration holes 121. The hole density of the section 122a and the hole density of the section 122b differ from each other.

### *** Effects of Embodiment 1 ***

Embodiment 1 provides a method for controlling the thermal expansion coefficient of the circuit board according to the thermal expansion coefficient of a mounted component.

Two or more regions with different penetration hole densities (porosity) are provided in the conductor part of the low thermal expansion conductor layer 112 of the printed circuit board 100. Thereby, it is possible to adjust the thermal expansion coefficient of the printed circuit board 100 for each region on which the component is mounted, and to decrease a difference in thermal expansion coefficients between the component and the printed circuit board 100. Therefore, it is possible to maintain a strain that occurs at a solder joint of a component mounting part to be less than or equal to a constant level by keeping the difference in thermal expansion coefficients to be less than or equal to a predetermined value.

On the region 120 of the conductor part of the low thermal expansion conductor layer 112, the penetration holes 121 are formed.

Thereby, the elastic modulus of the region 120 varies, and the apparent thermal expansion coefficient varies. It is possible to control the difference in thermal expansion coefficients between the region 120 and the mounted component by varying the thermal expansion coefficient.

Further, by varying the porosity for each region 120, it is possible to vary the apparent thermal expansion coefficient for each region 120, and it is possible to make the difference in thermal expansion coefficients between the region 120 and the mounted component corresponding to the region 120 the same, in the two or more regions 120.

Thus, it is possible to vary the thermal expansion coefficient that is directly below each mounted component, and to maintain the difference in thermal expansion coefficients between the component and the printed circuit board 100 at a constant level throughout the entire circuit board.

Further, it is possible to maintain a strain that occurs at a solder joint of a component mounting part to be less than or equal to a constant level by keeping the difference in thermal expansion coefficients between each mounted component and the printed circuit board that is directly below the mounted component to be less than or equal to a predetermined value.

When components are mounted on both the surface conductor layers 111 of the printed circuit board 100, the penetration holes 121 are formed in each of the regions 120 of the two or more low thermal expansion conductor layers 112 according to the thermal expansion coefficient of the component mounted on each of the surface conductor layers 111. Thereby, adjustment (matching) of the thermal expansion coefficient is possible. The positions of the penetration holes 121 in the two or more low thermal expansion conductor layers 112 may not consistent with each other in the board thickness direction.

In a component (a multi-chip module, for example) in which a plurality of chips are placed in a single package, the thermal expansion coefficient varies within the component.

When such a component is mounted on the surface conductor layer 111, a plurality of sections 122 are provided in the region 120 corresponding to the component. Thereby, it is possible to cope with the difference in thermal expansion coefficients within the component.

Embodiment 1 achieves the following effects.

In the printed circuit board 100 on which a plurality of different components are mounted, it is possible to consistently control differences in thermal expansion coefficients between the mounted components and the circuit board.

In the printed circuit board 100 on which a plurality of different components are mounted, it is possible to consistently control a strain that occurs at a solder joint of a component mounting part.

The effect of controlling the thermal expansion coefficient by the low thermal expansion conductor 102 can be enhanced by placing the low thermal expansion conductor layer 112 near a surface.

The low thermal expansion conductor 102 can be prevented from being a floating potential by electrically connecting the low thermal expansion conductor 102 to the wiring conductor 101 through the through hole 119. Further, it is possible to use the low thermal expansion conductor 102 as a heat pass.

The diameter of the through hole 119 being constant within the same through hole 119 enables the manufacture of multi-layer printed circuit boards.

When components are mounted on both surfaces, the positions of the regions 120 differ from each other in the planar direction in the two or more low thermal expansion conductor layers 112, so that it is possible to control the thermal expansion coefficient according to the components on both surfaces.

By gradually varying the hole densities of the penetration holes 129 toward the region 120, it is possible to gradually vary the thermal expansion coefficients toward the region 120 which is used for adjusting thermal expansion, and to alleviate stress concentration.

### *** Examples of Embodiment 1 ***

Hereinafter, examples related to the printed circuit board 100 will be described.

The number of low thermal expansion conductor layers 112 may be one, or may be three or more.

The number of same-type conductor layers 113 is not limited to two.

The same-type conductor layer 113 may be placed on the outer side of the low thermal expansion conductor layer 112.

However, when components are mounted on the surface conductor layer 111, it is preferable that there are few other materials between the mounted components and the low thermal expansion conductor layer 112. Therefore, it is preferable to place the low thermal expansion conductor layer 112 on a layer that is close to the surface conductor layer 111.

A layer configuration of the printed circuit board 100 may be asymmetric in the thickness direction.

However, the thermal expansion coefficients and elastic moduli of the low thermal expansion conductor layer 112, the same-type conductor layer 113, and the insulating layer 114 differ from each other. Therefore, when a temperature change occurs, different thermal stresses occur inside the printed circuit board 100. Then, when the layer configuration of the printed circuit board 100 is asymmetric in the thickness direction, the entire circuit board tends to warp. Thus, it is preferable for the layer configuration of the printed circuit board 100 to be symmetric in the thickness direction. In other words, it is preferable to place the low thermal expansion conductor layer 112 and the same-type conductor layer 113 symmetrically.

Copper is often used in the conductor layer. Further, silver paste may be used. In other words, silver may also be used.

The printed circuit board 100 is a layered body made of a large number of materials.

The total thermal expansion coefficient of a layered body made of n types of materials is determined by calculating formula (1).
[Formula 1] ${α}_{s} = \frac{{\sum }_{i = 1}^{n} {α}_{i} {Vf}_{i} {E}_{i}}{{\sum }_{i = 1}^{n} {Vf}_{i} {E}_{i}}$

"α" indicates the thermal expansion coefficient. The attached character s refers to the entire circuit board.

"Vf" indicates the volume fraction.

"E" indicates Young's modulus.

"i" indicates one of the n types of materials.

The total thermal expansion coefficient of the layered body is significantly affected by a material (a layer) whose elastic modulus is high. Further, the total thermal expansion coefficient of the layered body is significantly affected by a material (a layer) whose volume fraction is high.

A material whose thermal expansion coefficient is low and whose elastic modulus is high is preferable as a material used for the low thermal expansion conductor 102.

Specifically, a material whose thermal expansion coefficient is less than or equal to 8ppm/K is preferable. Further, a material whose elastic modulus is equal to or more than 200GPa is preferable. ppm stands for parts per million. "K" stands for kelvin. GPa stands for gigapascal.

A preferable material includes, for example, molybdenum (Mo), tungsten (W), or an alloy of these. Further, cemented carbide is also included as a material with a low thermal expansion coefficient and a high elastic modulus. Mo-Ti, Mo-Ti-C, Mo-Zr, TZM, TZC, Mo-Nb, and the like are included as molybdenum alloys. W-Ag, W-Cu-Ni, W-Fe-Ni, W-Ni-Co, W-Re, W-Re-Ta and the like are included as tungsten alloys. "Mo", "W" and the like are element symbols.

Further, a composite material of copper and the metals mentioned above such as a copper molybdenum composite material or a copper tungsten composite material is also included as a material with a low thermal expansion coefficient and a high elastic modulus. The copper composite material has a high thermal conductivity. From the perspective of heat dissipation, the copper composite material is a preferable material for the low thermal expansion conductor layer 112. Further, the copper composite material as described above is a preferable material for the low thermal expansion conductor layer 112 because the copper composite material is highly compatible with the manufacturing process of a circuit board that uses copper as the main conductor.

Further, a low thermal expansion alloy, a negative thermal expansion material, or a material composed of these is considered as a preferable material. An example of a low thermal expansion alloy is an invar alloy. Examples of negative thermal expansion materials are bismuth nickel iron oxide and zirconium tungstate.

A circuit board material used for the printed circuit board is used for the insulating material 103. A material (glass epoxy) impregnated with epoxy resin to fiberglass is used as the insulating material 103, for example.

PPE, cyanate, PTFE, polyimide, phenol or the like is included as an alternative to epoxy resin. PPE represents polyphenylene ether. PTFE represents fluororesin.

Aramid fiber is included as a fiber that is an alternative to fiberglass.

To adjust the thermal expansion coefficient of the conductor part of the low thermal expansion conductor layer 112, it is also possible to vary the thickness of the region 120 in the low thermal expansion conductor layer 112.

Further, the thickness around the region 120 may be gradually varied as it is further away from the region 120.

Examples related to the through hole 119 will be described below.

The through hole 119 may not be connected to the conductor part of the low thermal expansion conductor layer 112.

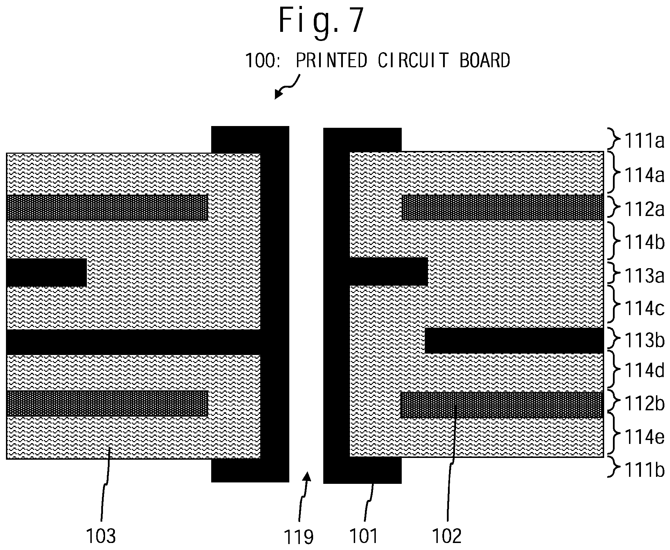

In Fig. 7, the through hole 119 is not connected to the conductor part of each of the low thermal expansion conductor layer 112a and the low thermal expansion conductor layer 112b.

The printed circuit board 100 may be provided with the through hole 119 that is connected to the conductor part of the low thermal expansion conductor layer 112, and the through hole 119 that is not connected to the conductor part of the low thermal expansion conductor layer 112.

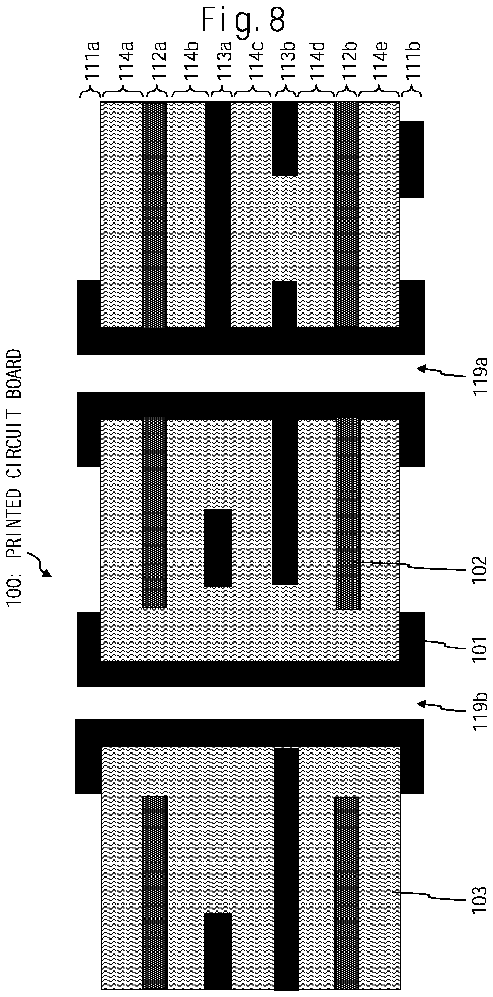

In Fig. 8, a through hole 119a is connected to the conductor part of each of the low thermal expansion conductor layer 112a and the low thermal expansion conductor layer 112b. On the other hand, a through hole 119b is not connected to the conductor part of each of the low thermal expansion conductor layer 112a and the low thermal expansion conductor layer 112b.

The through hole 119 is connected to the conductor part of at least one of the low thermal expansion conductor layers 112, and is not necessarily connected to the conductor part of another low thermal expansion conductor layer 112.

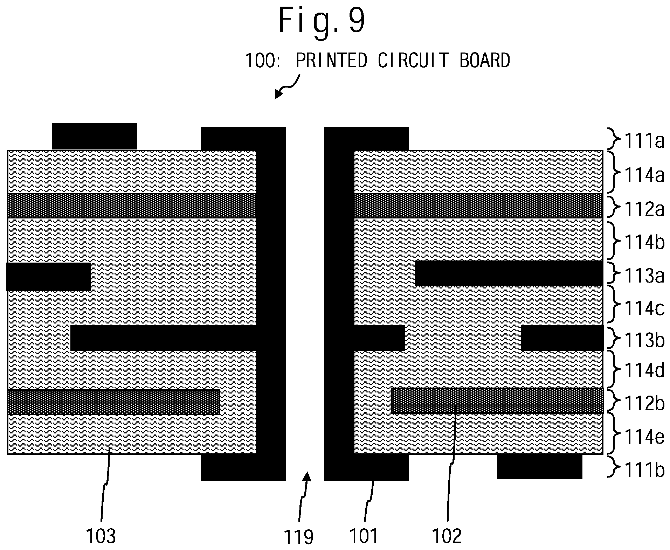

In Fig. 9, the through hole 119 is connected to the conductor part of the low thermal expansion conductor layer 112a. However, the through hole 119 is not connected to the conductor part of the low thermal expansion conductor layer 112b.

In at least one of the low thermal expansion conductor layers 112, the through hole 119 may not be provided in a hole provided in the conductor part.

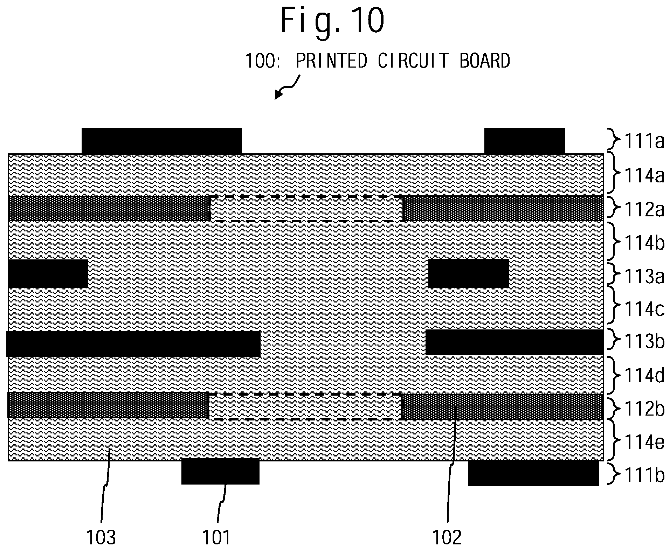

In Fig. 10, the through hole 119 is not provided in a hole (a part surrounded by a broken line) of the conductor part of each of the low thermal expansion conductor layer 112a and the low thermal expansion conductor layer 112b.

The sizes of holes in the conductor parts in the two or more low thermal expansion conductor layers 112 may differ from each other.

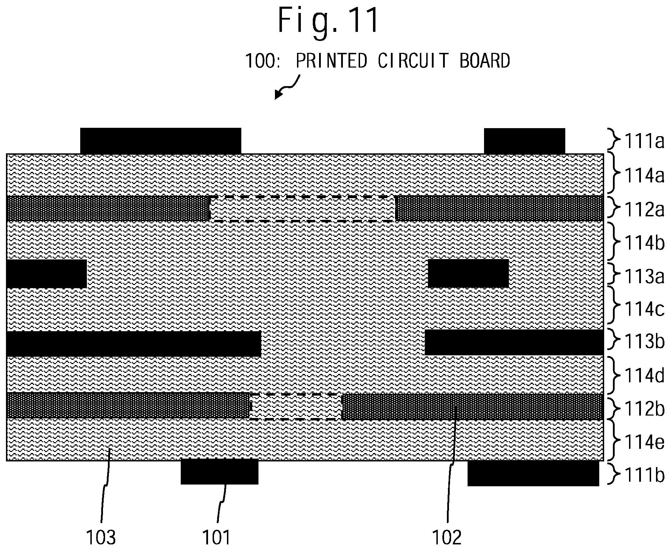

In Fig. 11, the size of the hole in the conductor part of the low thermal expansion conductor layer 112a and the size of the hole in the conductor part of the low thermal expansion conductor layer 112b differ from each other.

The positions of holes in the conductor parts in the two or more low thermal expansion conductor layers 112 may differ from each other.

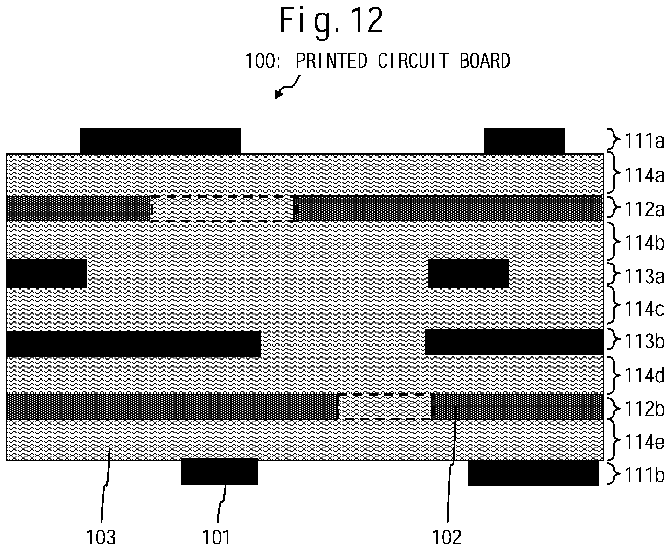

In Fig. 12, the position of the hole in the conductor part of the low thermal expansion conductor layer 112a and the position of the hole in the conductor part of the low thermal expansion conductor layer 112b differ from each other.

In at least one of the low thermal expansion conductor layers 112, it is not necessary to provide a hole in the conductor part.

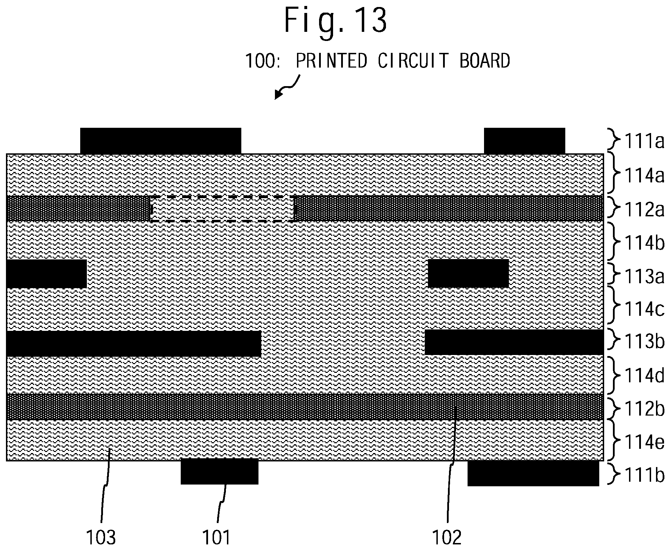

In Fig. 13, the hole is provided in the conductor part of the low thermal expansion conductor layer 112a. On the other hand, there is no hole in the conductor part of the low thermal expansion conductor layer 112b.

When a hole is formed in the conductor part of the low thermal expansion conductor layer 112 prior to the layering process of the printed circuit board 100, the hole in the conductor part of the low thermal expansion conductor layer 112 is temporarily filled with resin that constitutes the insulating material 103 during the manufacturing process of the printed circuit board 100.

When a hole or a through hole is formed in the conductor part of the low thermal expansion conductor layer 112 so as to penetrate the printed circuit board 100 after the layering process of the printed circuit board 100, the inside of the through hole or hole is hollow. Subsequently, it is also possible to fill the inside of the hole with resin, a hybrid of resin and functional filler, or metal. The functional filler is, for example, an inorganic filler such as alumina or a conductor filler such as silver-coated copper powder.

Hereinafter, examples related to the low thermal expansion conductor layer 112 will be described.

In the low thermal expansion conductor layer 112, the hole densities of the penetration holes (121, 129) may be adjusted depending on the sizes of penetration holes, may be adjusted depending on the number of penetration holes, or may be adjusted depending on both the sizes and the number of penetration holes.

When components are mounted on the surface conductor layer 111a, the region 120 in which the plurality of penetration holes 121 are formed and which is positioned directly below the mounted components, may be positioned not on the low thermal expansion conductor layer 112a that is close to the surface conductor layer 111a, but on the low thermal expansion conductor layer 112b that is far from the surface conductor layer 111a.

However, it is preferable for the distance between the region 120 which is used for controlling the thermal expansion coefficient of the low thermal expansion conductor layer 112, and the component mounting region of the surface conductor layer 111, to be small. Therefore, it is preferable to position the region 120 in relation to the mounted components on the low thermal expansion conductor layer 112 which is close to the surface conductor layer 111 on which the components are mounted.

When components are mounted on the surface conductor layer 111a, the region 120 in which the plurality of penetration holes 121 are formed and which is positioned directly below the mounted components, may be positioned on each of the two or more low thermal expansion conductor layers 112.

The penetration hole 121 may be provided throughout the entire low thermal expansion conductor layer 112, and the hole density of the region 120 may be lower than the overall hole density of the low thermal expansion conductor layer 112. Further, the penetration hole 121 may not be provided in at least one of the regions 120.

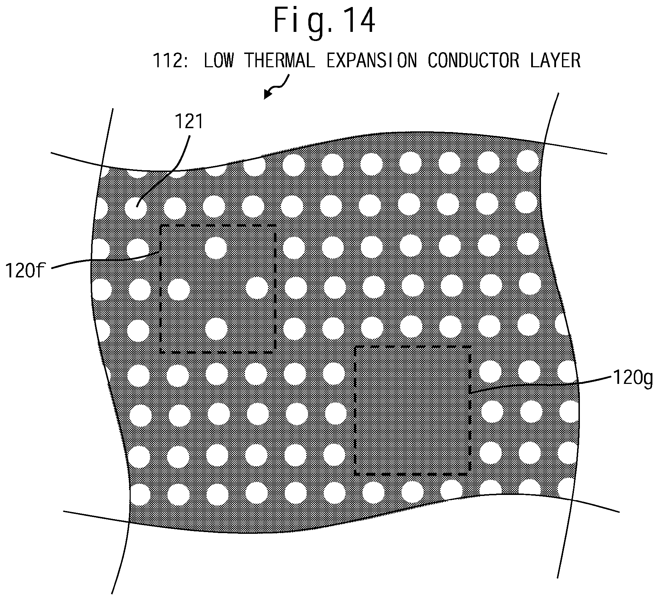

In Fig. 14, the penetration holes 121 are provided throughout the entire low thermal expansion conductor layer 112. The hole density of a region 120f is lower than the overall hole density of the low thermal expansion conductor layer 112. Further, the penetration hole 121 is not provided in a region 120g. Thus, the thermal expansion coefficient may be varied by reducing the hole density.

When the positions of the regions 120 in the planar direction in the two or more low thermal expansion conductor layers 112 differ from each other, at least a part of each of the regions 120 may overlap in the planar direction. Further, the region 120 of one of the low thermal expansion conductor layers 112 may be included in the region 120 of another low thermal expansion conductor layer 112 in the planar direction, or the entire region 120 of one of the low thermal expansion conductor layers 112 may overlap with a part of the region 120 of another low thermal expansion conductor layer 112 in the planar direction.

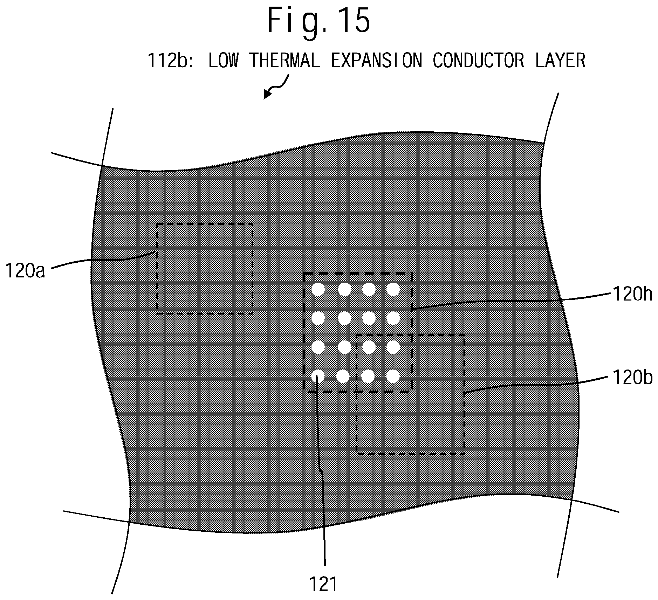

In Fig. 15, a part of a region 120h of the low thermal expansion conductor layer 112b overlaps with the region 120b of the low thermal expansion conductor layer 112a.

The shape of the penetration hole 121 may be a circle, oval, rectangle, or any other shape. The shape of at least one of the penetration holes 121 may differ from the shape of another penetration hole 121 in the same region 120. Further, the shape of the penetration hole 121 in at least one of the regions 120 may differ from the shape of the penetration hole 121 in another region 120.

The penetration hole 121 may have different lengths in the vertical and horizontal directions. Further, the plurality of penetration holes 121 may have their long sides aligned in one direction, or may have their long sides disordered in two or more directions.

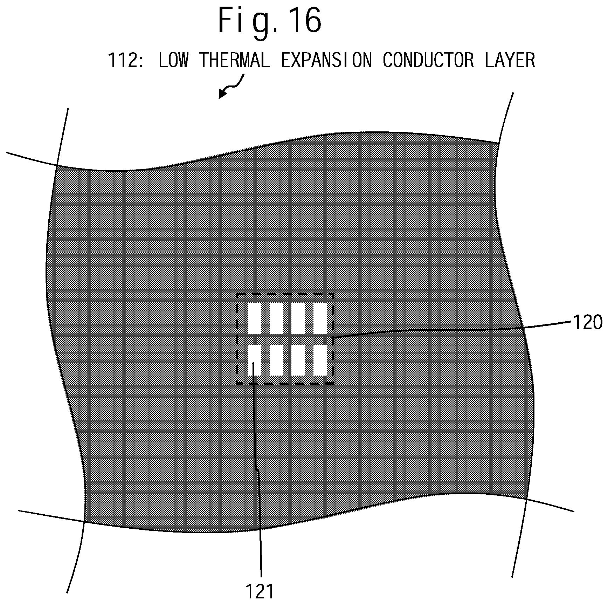

In Fig. 16, the shape of the penetration hole 121 in the region 120 is not a circle, but a rectangle. The penetration hole 121 has different lengths in the vertical and horizontal directions. Further, the eight penetration holes 121 in the region 120 have their long sides aligned in one direction (vertical direction).

In this case, anisotropy occurs in the thermal expansion coefficient of the region 120. The hole density of the region 120 in the horizontal direction is low and the hole density the region 120 in the vertical direction is high. Therefore, in the region 120, the thermal expansion coefficient in the horizontal direction is higher than the thermal expansion coefficient in the vertical direction.

When anisotropy occurs in the thermal expansion coefficients of mounted components, it is possible to adjust the thermal expansion coefficient of the printed circuit board 100 according to the thermal expansion coefficients of the mounted components by varying the aspect ratio of the penetration holes 121.

### *** Supplement to Embodiment 1 ***

Embodiment 1 is an example of a preferred embodiment and not intended to limit the technical scope of the present disclosure. Embodiment 1 may be partially implemented, may be implemented in combination with at least one of the examples, or may be implemented in combination with another embodiment or another example.

### Reference Signs List

100: printed circuit board; 101: wiring conductor; 102: low thermal expansion conductor; 103: insulating material; 111: surface conductor layer; 112: low thermal expansion conductor layer; 113: same-type conductor layer; 114: insulating layer; 119: through hole; 120: region; 121: penetration hole; 122: section; 129: penetration hole.

## Claims

1. A printed circuit board that is built with a plurality of layers comprising:
two surface conductor layers that are formed on upper and lower surfaces of the printed circuit board;
one or more internal conductor layers that are formed inside the printed circuit board; and
a plurality of insulating layers that electrically insulate the two surface conductor layers and the one or more internal conductor layers, wherein
the one or more internal conductor layers include one or more low thermal expansion conductor layers in which a conductor part is formed by a conductor whose thermal expansion coefficient is lower than those of conductors of the two surface conductor layers,
at least one of the one or more low thermal expansion conductor layers includes two or more regions in which a plurality of penetration holes are provided in the conductor part, and
hole densities of the two or more regions differ from each other.

2. A printed circuit board that is built with a plurality of layers comprising:
two surface conductor layers that are formed on upper and lower surfaces of the printed circuit board;
a plurality of internal conductor layers that are formed inside the printed circuit board; and
a plurality of insulating layers that electrically insulate the two surface conductor layers and the plurality of internal conductor layers, wherein
the plurality of internal conductor layers are composed of two or more low thermal expansion conductor layers in which a conductor part is formed by a conductor whose thermal expansion coefficient is lower than those of conductors of the two surface conductor layers, and one or more same-type conductor layers in which a conductor part is formed by a conductor of the same type as the conductors of the two surface conductor layers,
at least one of the one or more same-type conductor layers is positioned between any two of the low thermal expansion conductor layers, and
at least one of the two or more low thermal expansion conductor layers includes a region in which a plurality of penetration holes are provided, in the conductor part.

3. The printed circuit board according to claim 1 or 2 in which a through hole is provided to electrically connect the two surface conductor layers to at least one of the internal conductor layers.

4. The printed circuit board according to claim 3, wherein
the conductor of the through hole electrically connects the conductor of the two surface conductor layers to the conductor of at least one of the low thermal expansion conductor layers.

5. The printed circuit board according to claim 3 or 4, wherein
a diameter of the through hole is constant inside the printed circuit board.

6. The printed circuit board according to any one of claims 1 to 5 comprising
two or more low thermal expansion conductor layers, each of which includes the region in the conductor part, and whose positions of the regions in the planar direction differ from each other.

7. The printed circuit board according to any one of claims 1 to 6, wherein
a plurality of penetration holes whose hole densities gradually vary as the penetration holes are farther away from the region are provided in the conductor parts around at least one of the regions.

8. The printed circuit board according to any one of claims 1 to 7, wherein
a thickness of a part in at least one of the low thermal expansion conductor layers differs from a thickness of another part.

9. The printed circuit board according to any one of claims 1 to 8, wherein
at least one of the regions includes two or more sections in which a plurality of penetration holes are provided, and
hole densities of the two or more sections differ from each other.

10. The printed circuit board according to any one of claims 1 to 9, wherein
a position of each of the regions is the same as a position of one of component mounting regions of the two surface conductor layers in the planar direction.

11. The printed circuit board according to any one of claims 1 to 10, wherein
a shape of each of the penetration holes is a circle, oval, or rectangle.

12. The printed circuit board according to any one of claims 1 to 11, wherein
each of the penetration holes has different lengths in the vertical and horizontal directions, and the plurality of penetration holes have their long sides aligned in one direction.
